(19) Europäisches Patentamt / European Patent Office / Office européen des brevets

(11) **EP 2 728 746 B1**

(12) **EUROPEAN PATENT SPECIFICATION**

(45) Date of publication and mention
of the grant of the patent:
**29.07.2015 Bulletin 2015/31**

(51) Int Cl.:
*H03F 3/189* (2006.01)          *H03M 7/30* (2006.01)
*H03M 3/00* (2006.01)          *H03F 3/217* (2006.01)

(21) Application number: **12191285.1**

(22) Date of filing: **05.11.2012**

(54) **Signal modulation for radiofrequency communications**

Signalmodulierung für Funkfrequenzkommunikation

Modulation de signal pour des communications de radiofréquence

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.05.2014 Bulletin 2014/19**

(73) Proprietor: **ALCATEL LUCENT**
**92100 Boulogne-Billancourt (FR)**

(72) Inventor: **Dartois, Luc**
**91620 NOZAY (FR)**

(74) Representative: **Sciaux, Edmond**
**Alcatel-Lucent International**
**148/152 route de la Reine**
**92100 Boulogne-Billancourt (FR)**

(56) References cited:
**WO-A2-01/97384     WO-A2-92/15153**

- **CRAVEN P: "TOWARD THE 24-BIT DAC: NOVEL
NOISE-SHAPING TOPOLOGIES
INCORPORATING CORRECTION FOR THE
NONLINEARITY IN A PWM OUTPUT STAGE",
JOURNAL OF THE AUDIO ENGINEERING
SOCIETY, AUDIO ENGINEERING SOCIETY, NEW
YORK, NY, US, vol. 41, no. 5, 1 May 1993
(1993-05-01), pages 291-313, XP000432100, ISSN:
1549-4950**
- **MOHAMMAD MOJTABA EBRAHIMI ET AL:
"Delta-Sigma-Based Transmitters: Advantages
and Disadvantages", IEEE MICROWAVE
MAGAZINE, IEEESERVICE CENTER,
PISCATAWAY, NJ, US, vol. 14, no. 1, 1 January
2013 (2013-01-01), pages 68-78, XP011491633,
ISSN: 1527-3342, DOI: 10.1109/MMM.
2012.2226541**

## Description

### Field of the invention

The invention relates to the technical field of signal modulation devices and methods for radiofrequency communications, especially for providing an output signal to a radio frequency front-end, in particular a switched-mode power amplifier.

### Background

Switched-mode is an emerging technology for achieving high power efficiency in Radio Frequency (RF) power amplifiers. Switched-mode means that the power transistors are either in a fully conducting state or in a completely shut-off state. A filter at the output is then often needed to remove unwanted harmonics and quantization noise of the switch frequency.

A method of achieving a band pass RF signal is to use band pass sigma delta modulation (BPSDM) working at four times the RF carrier frequency. Developments based on this method are disclosed for example in EP-A1-2330734 or EP-A1-2403136. However such techniques lead to the constraints of generating four pulses per carrier period and having the whole digital chain, including BPDSM, work at a very high frequency higher than the wanted RF carrier frequency, which causes huge technology constraints.

Craven P. "Toward the 24-bit DAC: novel noise-shaping topologies incorporating correction for the nonlinearity in a PWM output stage", J. Audio Eng. Soc., Vol. 41, No 5. (XP000432100) discloses a nonlinear noise shaper, which includes a digital simulation of the intrinsic PWM non linearity and correction through feedback or a combination of feedforward and feedback.

WO-A1-2001/97384 discloses methods for reducing distortion and noise in high power digital PWM amplifiers by measuring the difference between the desired output signal and the actual output signal on a pulse by pulse basis.

WO-A2-9215153 discloses a signal convertor comprising a pulse modulator, and means for modifying the signal input thereto in dependence upon the error in previous values of the output thereof, to reduce the effects of the error within a desired signal band.

### Summary

In accordance with an object of the invention, the invention provides a signal modulation device in accordance with claim 1.

According to embodiments, such signal modulation devices can comprise one or more of the features below.

In embodiments, the device further comprises a digital predistortion table for mapping the quantized complex states of the intermediary signal to predefined predistorsion symbols, and a feedback loop for providing the predistorsion symbols to the sigma-delta modulator.

In embodiments, the digital predistortion table comprises a predefined predistortion symbol for each quantized complex state of the intermediary signal and each quantized state of the phase signal, and operates at each oversampling clock period to select a predistortion symbol as a function of the current quantized complex state of the intermediary signal and the current quantized state of the phase signal.

In embodiments, the predistorsion symbol associated to a complex quantized state of the intermediary signal and a quantized state of the phase signal is a function of an energy coefficient of the pulse train segment encoded by the corresponding quantized symbol at the carrier frequency and a complex phase coefficient corresponding to the quantized state of the complex phase signal.

In embodiments, the quantized symbol comprises a parallel binary sequence and wherein the pulse generator comprises a serializer adapted to serialize the parallel binary sequence at the second oversampling clock rate.

In embodiments, the phase signal is coded over a predefined number of bits, e.g. over 4 bits.

In embodiments, the numerical oscillator comprises a phase accumulator operating as function of a control signal defining the selected carrier frequency coded over the predefined number of bits and a clock signal at the first oversampling clock rate, the device further comprising a multi-stage low pass noise shaping sigma delta filter arranged to provide the control signal coded over the predefined number of bits by filtering a refined control signal coded over a higher number of bits.

In embodiments, the device further comprises a rate-adjustable clock arranged to provide a clock signal at the first oversampling clock rate, wherein the first oversampling clock rate is adjustable over a small adjustment range.

In embodiments, the symbol mapping table is obtained by executing the steps of: selecting an initial set of pulse train segments having a time-granularity corresponding to a second oversampling clock rate,

determining a complex energy coefficient of the pulse train segments of the initial set at the carrier frequency, and

for each quantized state of the phase signal,

computing a complex phase coefficient corresponding to the quantized state of the complex phase signal, and

selecting a subset of the pulse train segments of which the complex energy coefficients at the carrier frequency closely approximate the quantized complex states of the intermediary signal multiplied by the complex phase coefficient, so that each quantized complex state of the intermediary signal is uniquely mapped to a pulse train segment of the subset, e.g. the best fitting pulse train segment,

for each pulse train segment mapped to a quantized complex output state, recording a quantized symbol encoding the pulse train segment at a memory address associated to a combination of the quantized complex state of the intermediary signal combined and the quantized state of the phase signal.

In accordance with the object of the invention, the invention also provides a signal modulation method in accordance with claim 10.

Aspects of the object of the invention are based on the idea of enabling a choice of the carrier oversampling ratio, thereby limiting clock rate requirements. Aspects of the object of the invention stem from the observation that enabling a higher carrier frequency generation at a same oversampling clock rate helps reduce pulses density to relax constraints on power amplifiers and driver chains and therefore reduce power consumption in gate capacitors charge and discharge.

## Brief description of the drawings

These and other aspects of the invention will be apparent from and elucidated with reference to the embodiments described hereinafter, by way of example, with reference to the drawings.

Figure 1 is a functional representation of a radio frequency transmitter for digital communications.

Figure 2 is a functional representation of a signal modulation device that can be used in the transmitter of Figure 1.

Figure 3 is a graph showing a complex constellation that can be obtained with a sigma delta modulator of the modulation device of Figure 2.

Figure 4 is a schematic representation of pulse train segments that can be encoded in a symbol mapping table of the modulation device of Figure 2.

Figures 5 and 6 illustrate the complex constellation of a predefined set of pulse train segments at two different carrier frequencies.

Figure 7 is a schematic representation of pulse train segments meeting a twin-pulse constraint.

Figure 8 illustrates a complex energy constellation of a set of dual pulse train segments meeting a twin-pulse constraint at a carrier frequency.

Figure 9 is a schematic representation of pulse train segments meeting a P-0 constraint.

Figure 10 is a schematic representation of pulse train segments meeting a symmetry constraint.

Figure 11 is a schematic representation of pulse train segments meeting an oppositeness constraint.

Figure 12 is a schematic representation of pulse train segments meeting a complementarity constraint.

Figure 13 is a graph showing the spectrum of PPWM signal that can be generated with the modulation device of Figure 2.

Figure 14 is a time-domain graph showing a three-level pulse train that can be generated by the modulation device of Figure 2 in an example

Figure 15 is a time-domain graph showing a four-level pulse train that can be generated by the modulation device of Figure 2 in an example

Figure 16 is a functional representation of a signal modulation device that can be used in the transmitter of Figure 1 in accordance with another example

Figure 17 is a conceptual representation of a signal modulation device that can be used in the transmitter of Figure 1 in accordance with an embodiment.

Figure 18 is a functional representation of a signal modulation device that emulates the signal modulation device of Figure 17.

Figure 19 is a functional representation of a modified embodiment of the signal modulation device of Figure 18.

Figure 20 is a graph showing a complex energy constellation that can be obtained with a sigma delta modulator of the modulation devices of Figures 17 to 19.

Figure 21 is a flow diagram of a codebook selection method.

## Detailed description of the embodiments

There will be described a signal modulation device provided for a switched-mode power amplifier that can be used in wireless communications networks, for instance in 3G, 4G and above. The radio carrier frequencies used in such networks depend on both technical and regional spectrum regulatory constraints and range typically between 700 MHz and 2.7 GHz.

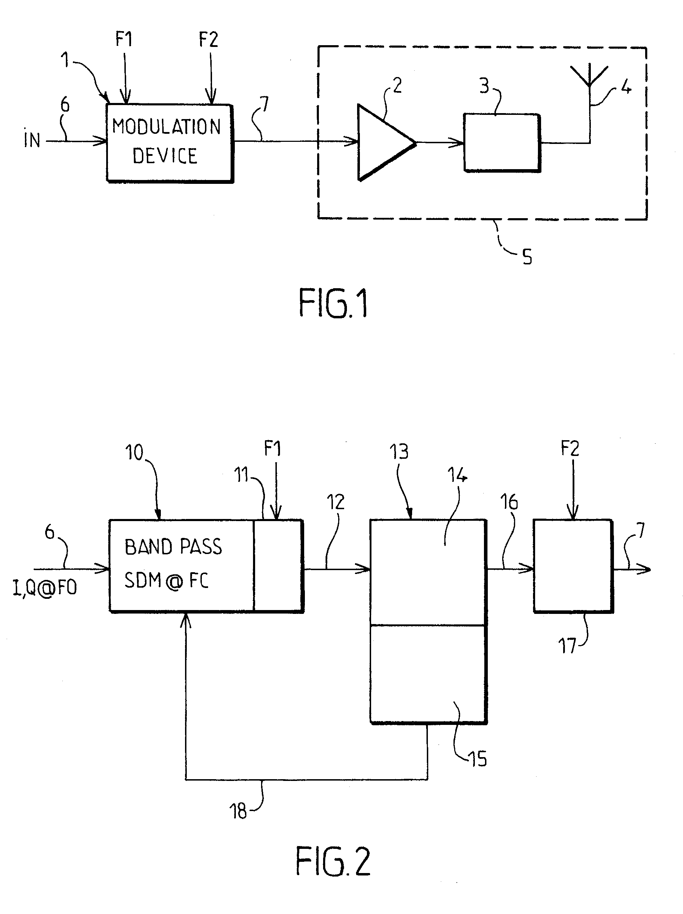

With reference to Figure 1, a digital RF transmitter is schematically depicted. The digital RF transmitter comprises a digital modulation device 1, a power amplifier 2, a band pass output filter 3 and an antenna 4. The power amplifier 2, band pass output filter 3 and antenna 4 can be referred to as a radio front-end 5, by contrast with digital modulation device 1.

The modulation device 1 comprises two quantizer stages that respectively operate at a first oversampling clock rate F1 and a second oversampling clock rate F2. A ratio between the oversampling clock rates F1 and F2 will be denoted by $N = \frac{F2}{F1}$.

The modulation device 1 receives a complex baseband signal 6 at an input. The sampling rate of the baseband signal 6 will be denoted F0. The oversampling ratio between the sampling rate F0 and the first oversampling clock rate F1 will be denoted by $M = \frac{F1}{F0}$.

In an implementation, the baseband signal 6 may be received as two parallel scalar components, i.e. an in-phase component denoted by I and a quadrature-phase component denoted by Q. In the following, there will be described signal processing methods applied to the complex baseband signal 6, e.g. sigma delta modulation. By virtue of linearity, the skilled person will appreciate that the sigma delta modulation of complex signals can be implemented as two parallel sigma delta modulation processes for each scalar component making up the complex signal.

The modulation device 1 transmits to the radio front-end 5 a frequency-converted time-domain pulsed signal 7 that encodes the information content of the baseband signal 6 in the position and/or width and/or amplitude of the pulses.

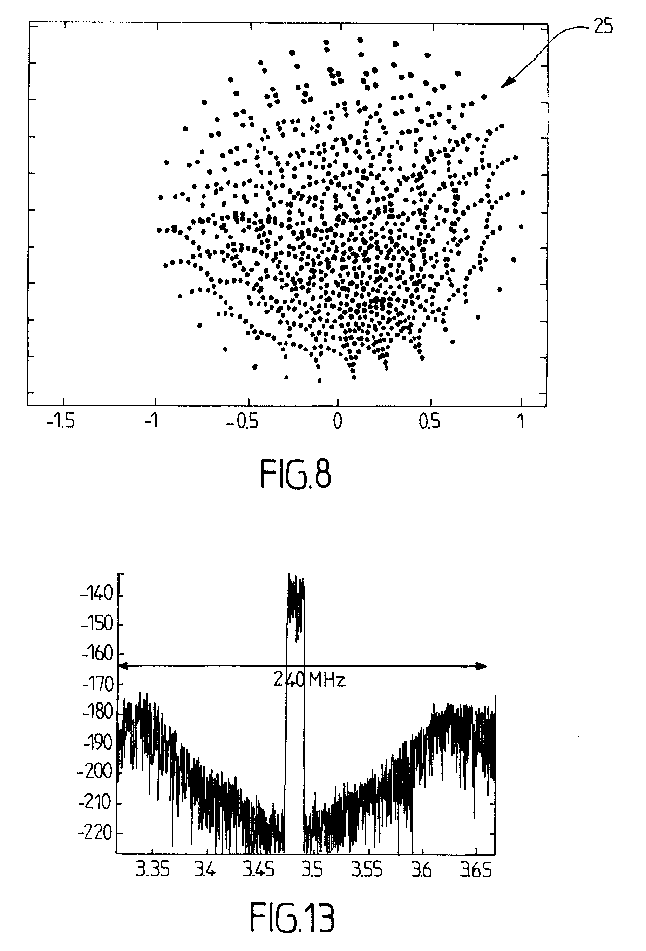

With reference to Figure 2, modulation device 1 will now be described, in which BPSDM is employed. As known in the art, a band pass sigma delta modulator operates to frequency-convert a useful information signal into a frequency band of interest, a.k.a. clean bandwidth, while rejecting quantization noise outside the frequency band of interest. The noise transfer function of such a modulator has a typical notched envelope that is illustrated in the simulation results of Figure 13. The quantization noise rejected outside the clean bandwidth can be post-filtered by the band pass output filter 3.

For the sake of conciseness, it will be sufficient to note that the band pass sigma delta modulator 10 of Figure 2 is designed so that its clean bandwidth is centered on a selected carrier frequency of the RF transmitter. The carrier frequency will be denoted by FC in the following. As BPSDM is a known technique, the skilled reader is referred to technical literature for further information about BPSDM implementation. A specific embodiment of an emulated band pass sigma delta modulator will also be described in a further portion of the present specification.

Hence, the modulation device of Figure 2 comprises the band pass sigma delta modulator 10 which is arranged to receive and process the baseband signal 6. The band pass sigma delta modulator 10 comprises a first quantizer 11, which operates at the oversampling clock rate F1 to deliver an intermediary signal 12 at an output. As an illustration, the oversampling ratio M may be between 10 and 30. The band pass sigma delta modulator 10 may typically include integration stages to the $3^{rd}$ or $4^{th}$ order to obtain a Signal-to-Noise ratio of about 60 dB or higher over up to 5% of the SDM band.

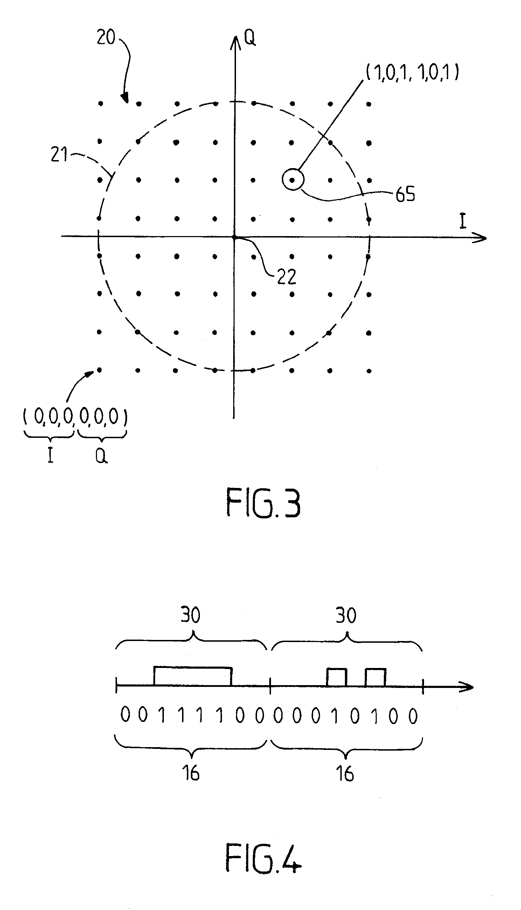

Hence, the intermediary signal 12 is a quantized complex signal that takes a quantized state within a given complex constellation 20 at each F1 clock period. In an embodiment, the quantized states of intermediary signal 12 are complex states coded over 6 bits, i.e. 3 bits for the I-component and 3 bits for the Q-component. Figure 3 illustrates the complex constellation 20 of the quantized states of the intermediary signal 12 in this embodiment. Of course, the quantizer 11 could produce a different number of states as well, i.e. to yield a richer or poorer constellation.

Next, a random-access memory 13 is provided to store a symbol mapping table 14 and a digital predistorsion table 15. The symbol mapping table 14 is accessed at each F1 clock period at a memory address associated to the current state of the intermediary signal 12 to deliver a quantized symbol stored at that address, a.k.a. pulse code 16. The pulse code 16 encodes a predefined pulse train segment that will be generated as the time-domain pulsed signal 7 by a pulse generator 17 upon receiving the pulse code 16 at each F1 clock period. The pulse generator 17 operates at the second oversampling frequency F2, so that the shortest pulse that can be generated is equal to the F2 clock period.

In an example the pulse code 16 is binary word having a word length equal to the oversampling ratio N and the pulse generator 17 is a serializer that generates a single-level pulse train segment 30 by serialization of the pulse code 16, i.e. a binary amplitude coded signal at the second oversampling frequency F2. An illustration of two such pulse codes 16 and corresponding pulse train segments 30 is shown on Figure 4.

Similarly, the digital predistorsion table 15 is accessed at each F1 clock period at a memory address associated to the current state of the intermediary signal 12 to deliver a complex predistorsion symbol stored at that address, a.k.a. complex power coefficient 18. The complex power coefficient 18 is fed back to the band pass sigma delta modulator 10 through a feedback loop to act as direct form predistorsion of the intermediary signal 12.

It will be appreciated that, in accordance with the above described functioning, a large variety of pulse trains can be generated, which mostly depend on the manner in which the symbol mapping table 14 has been populated. The symbol mapping table 14 operates as a dictionary, a.k.a. pulse codebook that predefines a finite set of pulse train segments of which the time-domain pulsed signal 7 is eventually constituted. Therefore the above-described system is highly adaptable. In particular, the selection of a pulse codebook can be optimized as a function of a number constraints and requirements of the application case.

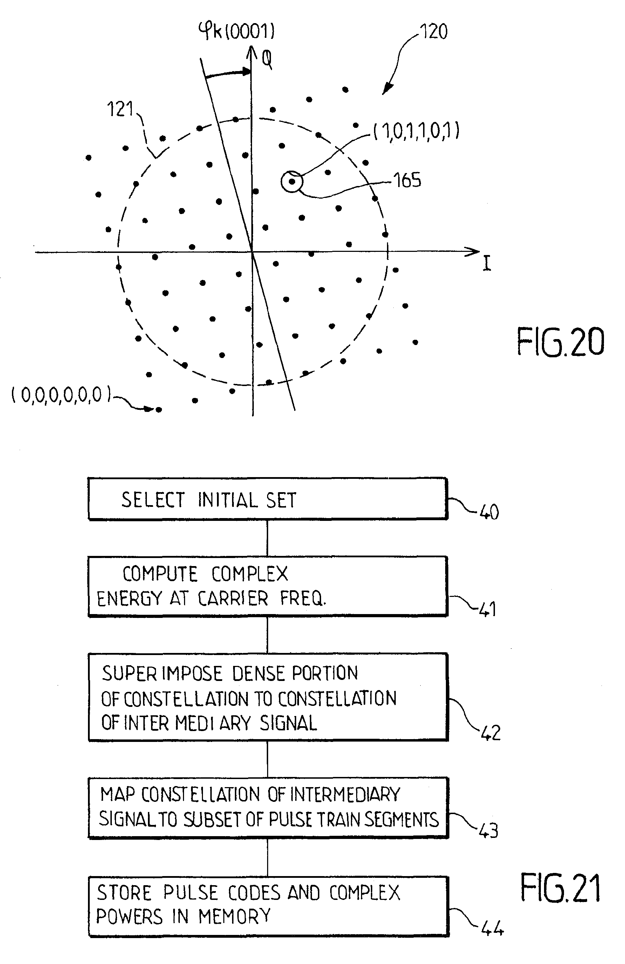

In reference to Figure 21, there will be described a method for selecting a pulse codebook and populating the symbol mapping table 14 and digital predistorsion table 15 accordingly. The selection of the codebook is intended to enable an adequate representation of all the quantized complex states of the intermediary signal 12. In the following, it is assumed that the intermediary signal 12 is limited by a constant envelope signal. Hence, the quantized states of intermediary signal 12 are confined, at least in a statistically significant manner, within a unitary circle representing nominal signal power. Such a unitary circle is depicted at numeral 21 in Figure 3.

The pulse codebook selection is an offline process that starts with the selection of an initial set of candidate pulse train segments at step 40. This initial selection may take into account more or less demanding constraints, i.e. to obtain a larger or smaller initial set of candidate pulse train segments.

A constraint to be taken into account is the binary word length of the pulse code. With single level pulses, the feasible binary word length is at most equal to the oversampling ratio N. For the sake of illustration, it will be assumed that the binary word length is equal to the oversampling ratio N in the following.

If the word length is the only constraint imposed, an initial set of $2^N$ (2 power N) pulse train segments ensues. Figure 4 illustrates two such pulse train segments 30 for N=8. Namely, the time length of a pulse train segments 30 is the F1 clock period and the time granularity of a pulse is the F2 clock period. The information of a pulse train segment is encoded in both the position and width of the pulses, a scheme referred to as Pulse Position and Width Modulation (PPWM).

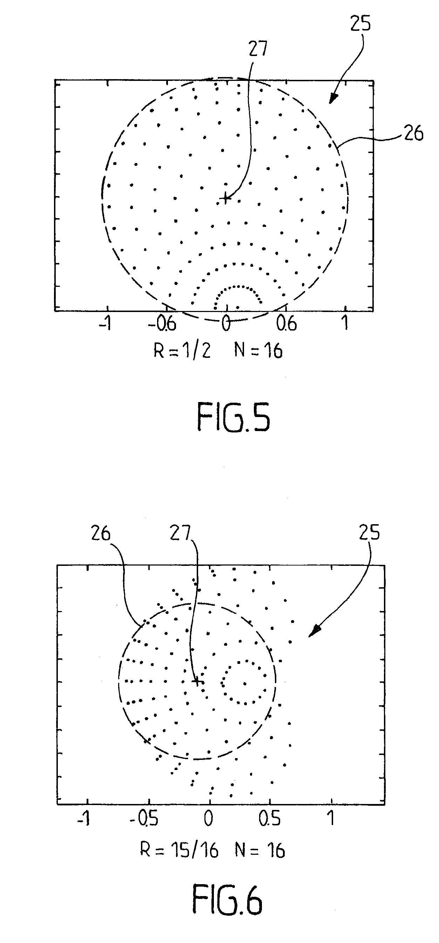

Once the initial set of candidate pulse train segments is identified, the method goes on to compute the complex energy of each candidate pulse train segment at the RF carrier frequency of interest FC at step 41. This computation can be done through direct Fourier transform of the time-domain pulse train segment. A complex constellation 25 of the candidate pulse train segments is obtained. Such constellations are illustrated in Figures 5 and 6 in an embodiment.

At step 42, optionally, the resulting complex constellation 25 is offset and/or scaled to superimpose a dense portion of the complex constellation 25 to the statistically significant portion of the quantized complex states of the intermediary signal 12. The offsetting of the constellation in the complex plane is equivalent to varying a continuous wave component of the pulse train segment, which has no practical implication on the emitted RF signal. The scaling of the constellation is equivalent to varying a peak energy of the pulses.

In an example step 42 can be implemented as follows: a center 27 of the original complex constellation 25 is determined through geometrical considerations, as a center of mass of the useful part of the complex constellation 25. Then the center 27 is offset to match with the center 22 of the complex constellation 20. Then the largest circle 26 inscribed within the complex constellation 25 is determined. Then the constellation 25 is scaled to match the radius of circle 26 with the radius of circle 21. This corresponds to adjusting the SDM loop gain and defining peak energy of the input I-Q signal.

The method goes on to step 43 in which a distance optimization method is applied to find a closest mapping symbol within the constellation 25 - potentially offset and/or scaled as the case may be - for each complex quantized state within the constellation 20. For example, a complex quantized state is selected within the constellation 20, then the complex plane distance of that state to each point in the constellation 25 is computed and the constellation point of constellation 25 that minimizes that distance is selected as the mapping symbol. Although the mapping is explained in the frequency domain, i.e. through the energy of samples at carrier frequency FC, it should be noted that a selection of time-domain signals ensues, i.e. a subset of the candidate pulse train segments is selected as those pulse train segments of which the complex energy at the carrier frequency FC most closely matches the quantized complex states of the intermediary signal 12. The remaining irreducible mismatch between the best matching pulse train segments and the complex states of intermediary signal 12 will cause the final quantization noise as a systematic error of the method. However, the level of that systematic error can be controlled. Of course, the higher the oversampling ratio N, the lower the systematic quantization noise because the accessible codebook becomes richer with growing parameter N.

At step 44, for each selected pulse train segment, the complex energy at the carrier frequency FC is stored in predistorsion table 15 at an address associated to the corresponding quantized complex state of the intermediary signal 12 and the pulse code encoding the pulse train segment is stored in mapping table 14 at an address associated to the corresponding quantized complex state of the intermediary signal 12.

There will now be described different rules that may be used at step 40 for the initial set selection.

A first class of rules consists in limiting the number of signal transitions in an F 1 clock period, with a view to reduce power consumption and needed amplifier bandwidth in the radio front-end 5. In particular, the number of pulses per pulse train segment can be limited to one in this manner, by limiting the number of 0-1 transitions and the number of 1-0 transitions to one per pulse train segment, a.k.a. single-pulse constraint. As an illustration, 37 pulse train segments meet the single-pulse constraint within the unconstrained set of 256 for 8 bits pulse codes. Figure 4 shows a pulse code 00111100 that meets the single-pulse constraint and a pulse code 00010100 that does not. Similarly, 137 pulse train segments meet the single-pulse constraint for 16-bits pulse codes.

The single-pulse constraint is further illustrated by Figures 5 and 6 that show complex constellations 25 obtained by applying that constraint. In those examples, the carrier frequency FC is defined through the frequency

$$\text{ratio} = \frac{FC}{F1}.$$ It is observed that the circularity of the constellation 25, and hence the number of usable pulse train segments within the circle 26, varies as a function of ratio R. Namely, the circularity improves when R becomes closer to 1/2.

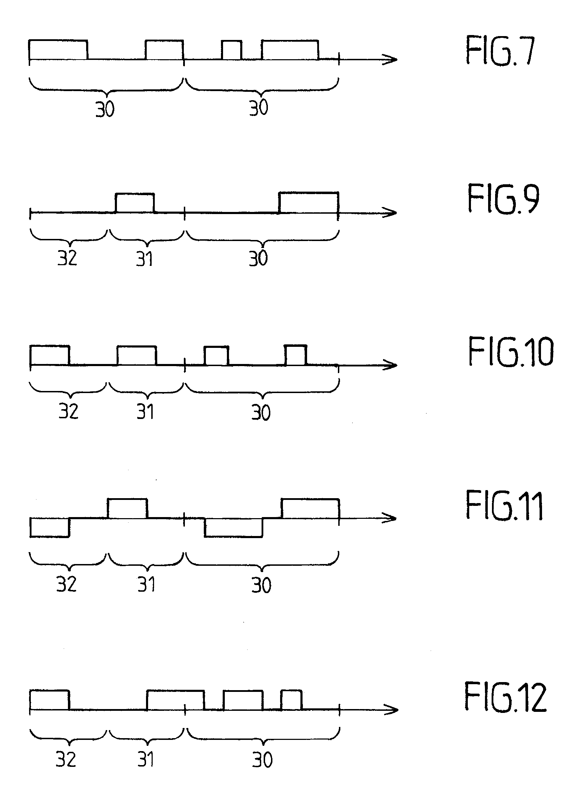

Figure 7 illustrates a different selection constraint, namely imposing two pulses per pulse train segment with each pulse having a length lower than N/2, a.k.a. twin-pulse constraint. As a consequence, more information is coded at the expense of more pulses per carrier period. For N=16, an initial set of $37^2=1369$ pulse train segments is obtained. Figure 8 illustrates the corresponding complex constellation 25.

Selection constraints can also be enforced to emphasize the resulting signal in specific parts of the spectrum. In an illustrative example of such constraints, a pulse train segment 30 is divided in two half-segments 31 and 32 and a specific rule is applied to define the second half 32.

Figure 9 illustrates a case in which the second half 32 is uniformly zero, i.e. no pulse is allowed in second half 32. This rule can be used to reduce pulse density at low power, e.g. 6dB backoff.

Figure 10 illustrates a case in which the second half-segment 32 is a duplicate of the first half-segment 31. This rule can be used to reduce spectrum noise and images above 0.5F1.

In an example the codebooks resulting from the rules illustrated in Figures 9 and 10 can be employed in a same transmitter device enforcing an additional code book selection step as a function of signal power. Namely, the code book of Figure 9 is used at lower power and the code book of Figure 10 is used at higher power. This will reduce the number of pulses per carrier period by 2 at low power while keeping good encoder efficiency, similar to Doherty effect.

In a modified example both constellations resulting from Figures 9 and 10 are concatenated at step 40. Therefore, the SDM feedback loop eventually operates to switch from one codebook (Figure 9) to the other (Figure 10) depending on average and peak energy of input signal 6.

Figure 11 illustrates a case in which the second half-segment 32 is the opposite of the first half-segment 31. This rule can be used to reduce spectrum noise and images around 0 and 2*F1 frequencies, i.e. 0 modulo 2*F1. This is a suitable choice for carrier frequency FC close to F1 and a high pass driver chain in the radio front-end 5. In fact, no energy of noise exists close to DC so that no risk of envelope reconstruction in an AC coupled driver chain ensues, which help keep clean binary pulses along the chain.

Figure 12 illustrates a case in which the second half-segment 32 is the complementary of the first half-segment 31. This rule can be used in similar conditions as Figure 11 and further provides adequate PWM carrier suppression at frequency F1 to improve the encoder efficiency. Those filtering effects come at the expense of doubling the second oversampling clock rate F2, and hence doubling ratio N and number of pulses per carried period, a.k.a factor K.

Quantitative examples

A 4WCDMA radio transmission was simulated by computer.

In a first simulation result, the parameters and results are: FC = 1.875GHz ; M=2; F1=2GHz ; N=16 ; F2=32GHz ; K=3.04 ; ACLR=73.3dB ; unfiltered 60dB ACLR bandwidth=88MHz ; max IBW= 60 MHz ; unfiltered coding efficiency over DC to 2*F1=85.1% ; filtered coding efficiency over DC to 2*F1=96.1% ; filtered 60dB ACLR bandwidth=140MHz. The code book is constrained by the complementary rule (Figure 12) together with the single-pulse rule in the first half-segment.

In a second simulation result, the modified parameters are only: FC = 2.125GHz ; M=0.9412. The results are only modified as: K=2.73 ; ACLR=74dB ; filtered coding efficiency over DC to 2*F1=96.9%.

It is observed that PPWM constellations enable robust efficiency and ACLR towards input backoff. Efficiency and ACLR degrade slowly over the first 10dB backoff.

Figure 13 illustrates the spectrum of the pulsed time-domain signal 7 obtained in a similar simulation case in which: FC = 2.125GHz ; F1=2GHz ; N=32 ; F2=64GHz. The code book is constrained by the complementary rule (Figure 12) together with the single-pulse rule in the first half-segment.

In the foregoing, reference has been made to single-level pulse trains. However, similar mapping and coding methods are applicable to richer constellations in which a quantized pulse-level dimension is added, i.e. pulse train segments including multi-level pulses. It will be appreciated that doubling the number of amplitude states of the pulses will cause a quadratic expansion of the constellations. Such multi-level pulse trains are especially suited to drive multi-branch power amplifiers in which the multi-level pulse train is eventually converted to plural parallel single-level pulse trains, so that each parallelized single-level pulse train drives a respective amplifier branch to switch only part of the total power.

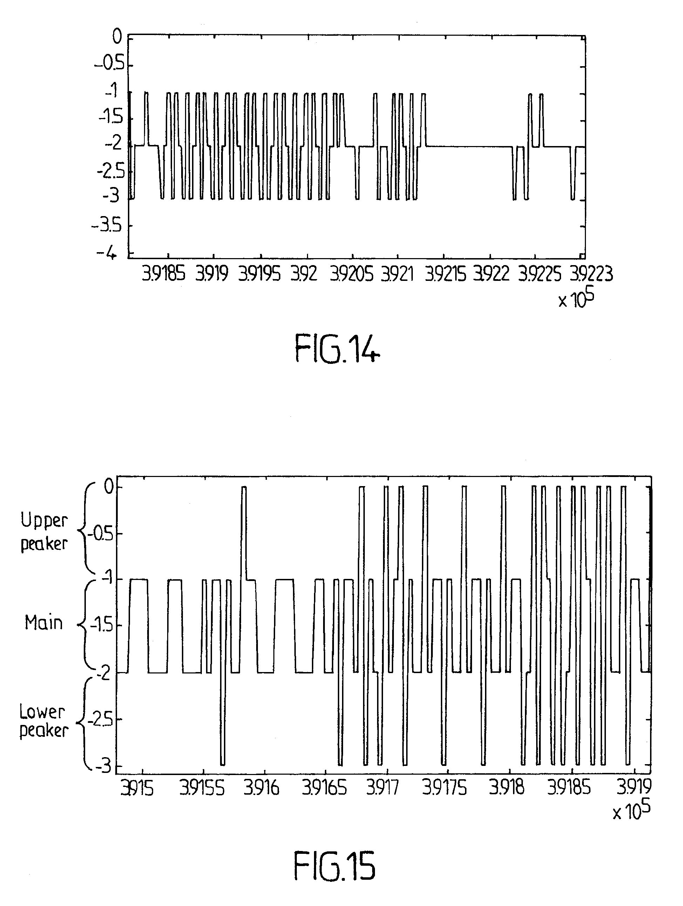

Examples of the above multi-level principle will be described in reference to Figures 14 and 15.

In Figure 14, a simulation result in shown of a 3-level pulse train suitable to drive a 2-way symmetric pulse feed type amplifier. The simulation parameters are: N=8 ; FC=2.125MHz ; F1=2GHz ; F2=16GHz. Two independent parallel single-level pulse sequences are generated with a code book constrained by the complementary rule (Figure 12) together with the single-pulse rule in the first half-segment. These parameters imply that a code book of 11 pulse trains is generated with 2 pulses per train. The summed result is a pulse train taking 3 relative values -1 ; ;0 ; +1, i.e. with a total of 51 multi-level pulse trains in the resulting codebook. The 2-way symmetric pulse feed type amplifier can be realized with a tristate class S scheme.

By employing two branches in amplitude, some properties of the legacy multi-branch Doherty amplifiers can be retrieved. The following examples mimic a 2-way asymmetric 1:2 pulse feed Doherty and a 3 way symmetric pulse feed Doherty

In the 2-way asymmetric 1:2 pulse feed Doherty case, two independent parallel single-level pulse sequences are generated with a code book constrained by the complementary rule (Figure 12) together with the single-pulse rule in the first half-segment. These parameters imply that a code book of 11 pulse trains is generated with 2 pulses per train. The second sequence has double amplitude compared to the first sequence. Hence, two same but de-correlated pulse train segment codebooks are generated, each taking two levels, respectively 0-1 and 0-2. The summed result is a pulse train taking 4 relative values - 1.5 ; -0.5 ; +0.5 ; +1.5, i.e. with a total of 121 multi-level pulse trains in the resulting codebook. An optimal average K=1.45 pulses per carrier period is observed. By feeding each train to a power amplifier branch, an asymmetric Doherty is emulated.

The case of a 3-way symmetric pulse feed Doherty amplifier is illustrated in Figure 15. The same codebook and constellations are employed as in the previous 2-way asymmetric case, with only differences in the power amplifier feed. Namely, the scheme uses three even branches in a Doherty way. The initial 3-level pulse train is converted into 3 binary pulse trains at the same clock speed F2=16GHz. There results one main pulsed signal and two even peakers acting respectively for upper and lower envelope peaks. The other parameters of the simulation are N=8 ; FC=2.125MHz and F 1 =2GHz.

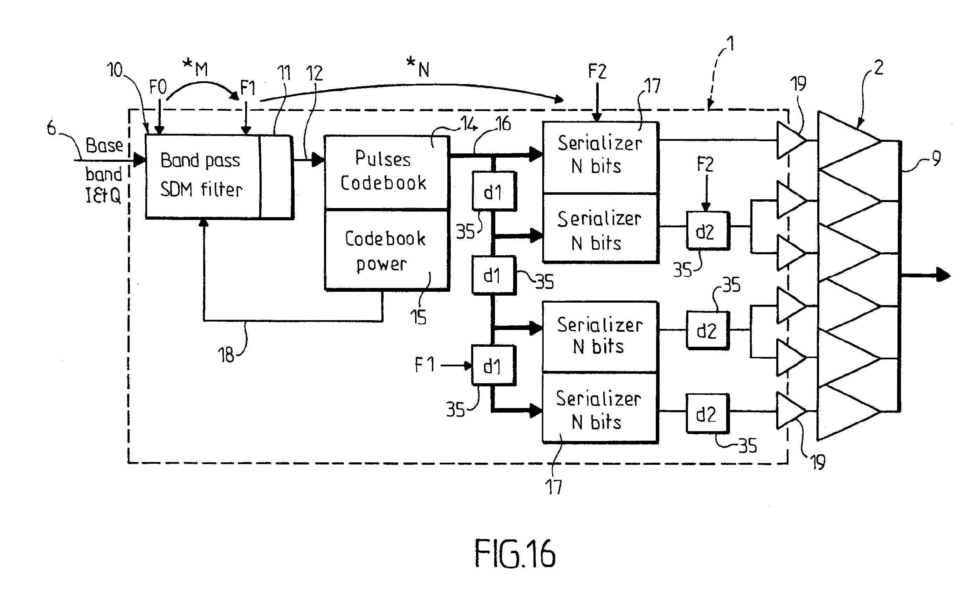

Figure 16 shows another example of the modulation device 1 comprising additional FIR filters for digital filtering. Elements identical or similar to those of Figures 1 and 2 are designated by the same numeral.

The power amplifier 2 is made of 6 small drivers and power transistors with 6 even groups of fingers. A spatial FIR filtering is added in the modulation device 1 with low quantization and limited number of taps to map onto the 6 distributed drivers 19 of the last stage transistors fingers. The summing point of the fingers, i.e. amplifier drain 9 is the filter output.

The figure shows an example with 4 taps and 6 identical fingers: the 4 taps [½ 1 1 ½] are iso-spaced to create a periodic frequency response: one harmonic falls onto FC with some stop bands close to the PPWM carriers and the SDM images modulo F1.

Taps delays 35 can be programmable by digital delay trees and one serializer per tap. The arrangement provides programmability to adapt to both FC and IBW targets as well as compensate for amplifier geometry delays and phase imbalance between fingers, especially larger dies and power.

The FIR performances are very robust to tap finger gain mismatch, e.g. as high as 20% mismatch, which is usually slightly more than fingers mismatch on a same power transistor die. The filter taps 35 clean up the SDM PPWM noise for example in RX band or adjacent TX band. However, it does not increase the encoder efficiency, as cancelled TX noise is simply dissipated in the PA last stage die.

In the foregoing, a method for computing the complex energy to store in the predistorsion table 15 was described. In an embodiment, the predistorsion table 15 is populated through experimental measurements of the complex energy of the selected pulse train segments at the carrier frequency FC. Such measurements bring about the benefits of taking into account the analogical properties of the radio-front end 5, such as finite transition slopes, memory effect of drivers and the like.

In fact, the analogical properties of the radio-front end 5 cause the spectrum of the radiated electromagnetic field to be slightly different from the spectrum of the output signal 7 of the pulse generator 17. However, a better efficiency of the predistortion feedback loop can be obtained by taking into account the pulsed signal that was actually radiated by the antenna 4 rather than its ideal digital representation. For that purpose, the complex energy coefficients 18 can be determined or refined through experimental measurements, which can be conducted as follows: the sigma delta modulator 10 is controlled to repeat a given pulse train segment over an adequate measurement period, during which a detector is employed to measure the amplitude and phase of the radiated field about the carrier frequency FC. The measured phase is a relative phase with respect to a given reference, e.g. any pulse train of the codebook having non zero energy and a measurable phase at the carrier frequency FC. For error minimization the reference pulse should preferably be one with high energy at the carrier frequency FC a.k.a preferably on the periphery of the constellation. The process is repeated for all pulse train segments of the codebook and the predistorsion table 15 is populated accordingly.

While the foregoing describes methods for selecting specific codebooks optimized for specific applications, it should be noted that the tables 14 and 15 may also be populated to generate well-known coding schemes, e.g. a conventional PWM coding scheme. As PWM generation is well known in the art, this alternative need not be further detailed.

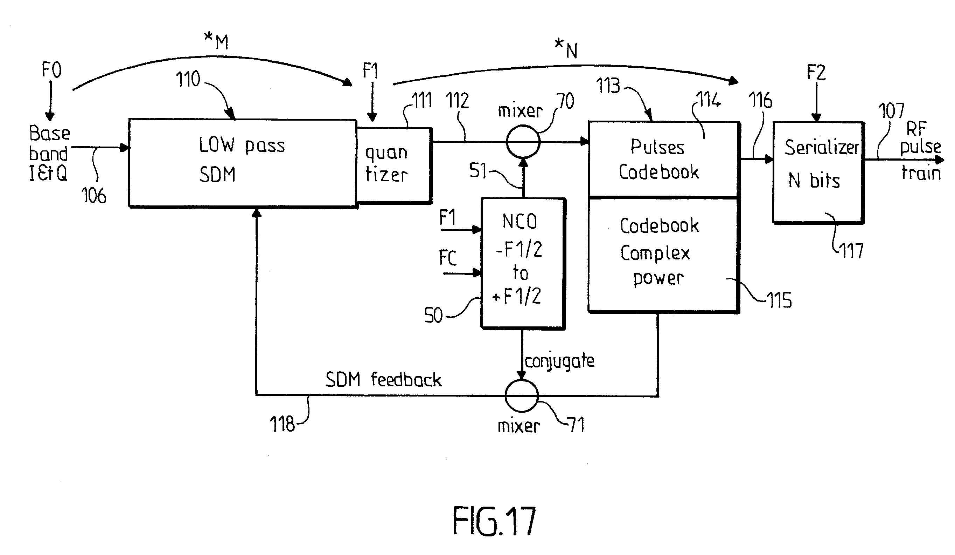

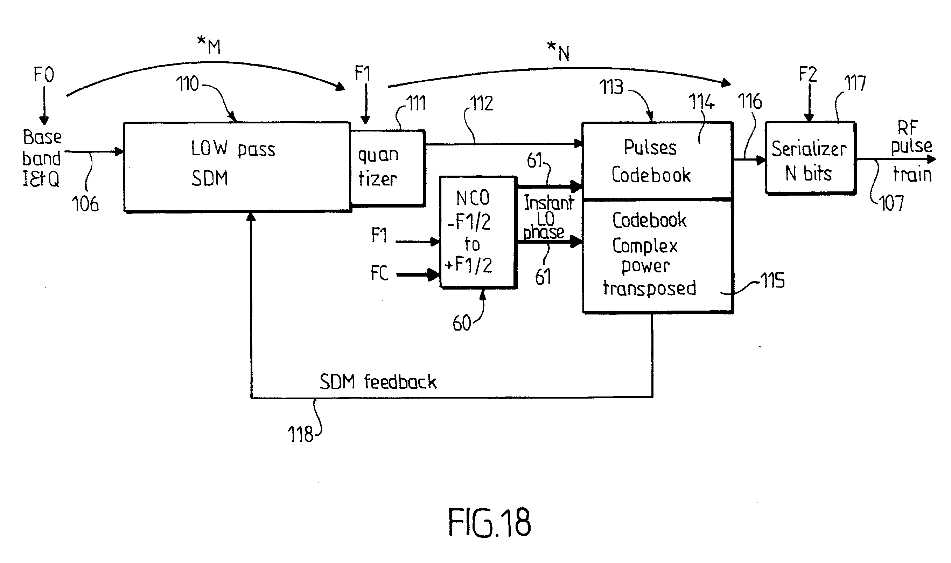

Turning now to Figures 17 and 18, an embodiment of an emulated band pass sigma delta modulator will be described. Elements which have a similar function to those previously described in Figures 2 and 3 are designated by the same reference numeral increased by 100.

A basic idea in Figures 17 and 18 is to emulate a band pass sigma delta modulator by using a low pass sigma delta modulator 110 together with a numerically controlled oscillator (NCO) 50 for effecting two digital frequency transpositions at the carrier frequency of interest FC, i.e. a first digital transposition by a first mixer 70 located between the first quantizer 111 and the mapping table 114 and a second digital transposition by a second mixer 71 located in the feedback loop of the sigma delta modulator 110.

The low pass sigma delta modulator 110 has a clean bandwidth centered on DC (0Hz) of which the width may be about 5% of the oversampling frequency F1, and operates to reject quantization noise outside that low frequency band.

The numerically controlled oscillator 50 is a digital generator which creates a clocked discrete-time, discrete-valued representation of a sinusoidal waveform which oscillates at a controlled frequency. In Figure 17, the NCO 50 receives the clock signal at the oversampling frequency F1 and a control signal set to impose the carrier frequency of interest FC. Namely, the NCO 50 delivers at each F1 clock period a complex digital number 51 which approximates the instantaneous value of a complex sinusoidal carrier wave oscillating at carrier frequency FC.

The mixer 70 is a complex multiplier that multiplies the quantized complex intermediary signal 112 delivered by quantifier 111 by the complex digital number 51, to produce the up-converted intermediary signal 52. Since the output signal 51 is coded over a finite number of bits, the up-converted intermediary signal 52 is also coded over a finite number of bits and can be used, as in the foregoing, to access a symbol mapping table 114 and a digital predistorsion table 115. However, a difference with the foregoing embodiments lies in the fact that the number of complex quantized states of the up-converted intermediary signal 52 will generally be much higher than the number of states of intermediary signal 112. This point will be illustrated in reference to Figure 20.

In Figure 20, the complex constellation of intermediary signal 112 is assumed to be identical to that of intermediary signal 12. Figure 20 actually shows a constellation 120 obtained by rotating the complex constellation 20 of Figure 3 by a certain instantaneous phase angle $-\varphi_k$, so as to represent the multiplication of intermediary signal 112 by a complex number $e^{-i\varphi}_k$ at mixer 70. It should be noted that a respective rotated constellation 120 will be obtained for each different phase the NCO output signal 51.

Therefore, in order to exploit a symbol mapping table 114 and a digital predistorsion table 115 in the same manner as in the foregoing, the tables have to be populated for each quantized state of quantifier 111 in each and every possible rotated constellation 120, which causes the table size to be expanded by a factor equal to the number of discrete values of the phase angle $\varphi_k$. This observation implies to code the instantaneous phase over a rather limited number of bits, e.g. 4 bits or 16 discrete values, otherwise the memory access time may become too long and disturb SDM stability.

Since the digital predistorsion table 115 is populated with complex energy coefficients derived from a rotated constellation 120, the mixer 71 must operates to multiply the retrieved coefficient by the conjugate value of output signal 51 prior to feeding it back to SDM modulator 110.

The above operations is a rather conceptual view because complex mixers 70 and 71 are complex digital multipliers which cannot be realized at the carrier frequency of interest, e.g. a few GHz, without a huge delay that would jeopardize the bandwidth of SDM modulator 110 and the stability of the feedback loop. In reference to Figure 18, a preferred embodiment based on the same concept will now be described, in which the operations of multipliers 70 and 71 are substituted with pre-computations that are swallowed up in the symbol mapping table 114 and a digital predistorsion table 115.

In Figure 18, the NCO 60 delivers a time-domain quantized signal 61 that represents the instantaneous phase $\varphi_k$ of the carrier wave oscillating at the selected carrier frequency FC. In an embodiment, the quantized phase signal 61 is coded over 4 bits. The post quantizer mixer 70 is now made implicit by increasing address field that serves for pulse code selection by NCO bits, e.g. 4 bits, which represent the quantized instant phase of a digital local oscillator. This point will be better understood by comparing again Figures 3 and 20.

In Figure 3, a quantized state of the constellation 20 can be uniquely represented by a 6-bit address, e.g. address 101101 for the circled state 65. By contrast, in Figure 20, keeping in mind that there exists a rotated constellation 120 for each discrete value of the phase angle $\varphi_k$, a quantized state of the constellation 120 can be uniquely represented by a 10-bit address e.g. address 101101//0001 for the circled state 165. This is because both the amplitude of components I and Q and the instantaneous phase angle have to be combined to define an individual state.

In view of the above, the codebook selection methods described in reference to Figure 21 can be employed to populate the table 114, yet with each and every rotated constellation 120. As a consequence, the codebook size will be expanded by a factor 16 for a phase signal 61 coded over 4-bits.

As for the resulting complex energy coefficients 118, multiplication by the conjugate factor number $e^{i\varphi}_k$ must be made prior to storing in the digital predistorsion table 115, as a substitute to employing mixer 71.

For the rest, the operation of memory 113 and pulse generator 117 is similar to that of memory 13 and pulse generator 17 and need not be described further.

The above described method for emulating a local oscillator enables to shift the clean bandwidth of the low pass SDM modulator 110 to a desired RF carrier frequency band that is only constrained by the oversampling clock rate F1. The NCO 50 or 60 controls the spectrum translation, so that the carrier frequency is selected by the NCO 50 or 60 anywhere between 0 and F1. With special band pass pulse trains (see Figure 12), even the second Nyquist zone can be selected.

As a consequence, sub GHz cellular bands can be synthesized with the same instant clean bandwidth as upper bands, e.g. 2 GHZ and with same the SDM clock rate F1. In an embodiment, a digital radio transmitter is obtained which is adapted to cover 700 to 2200 MHz while using fixed clocks at rates F1 and F2.

For a better frequency resolution, the number of bit of NCO output signal 61 must be larger. As an example, a 10MHz step for F1=2GHz clock implies to code the phase over 8 bits. An expansion factor of 256 ensues for the mapping tables that may cause access time issues at such a high speed. Therefore the instant phase signal is preferably limited to 3 or 4 bits.

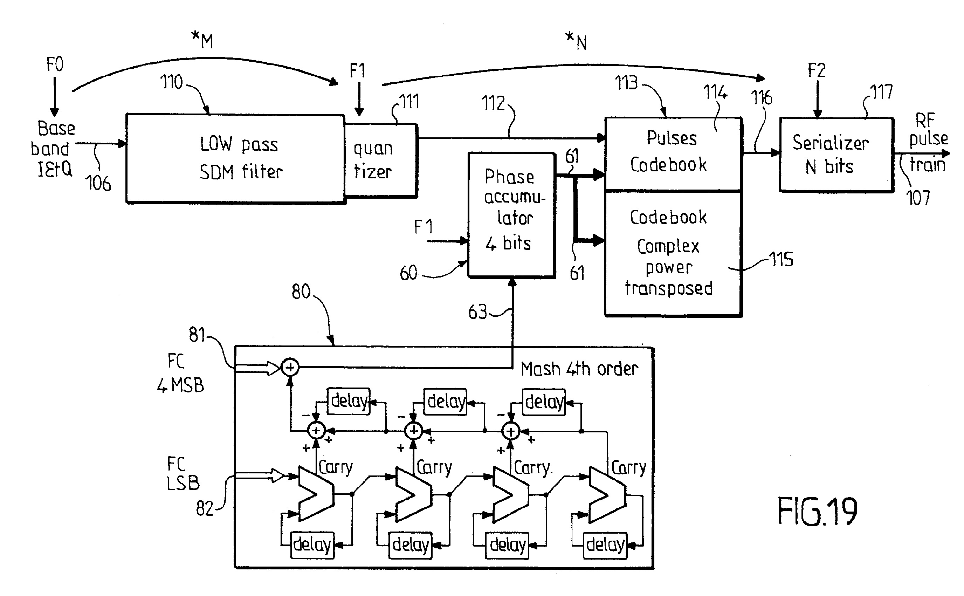

With reference to Figure 19, another embodiment based on the same principle employs a MASH noise shaping filter 80 to generate the NCO phase signal 61. Namely the control signal 63 of the NCO 60 is delivered through a dithering engine made of a Mash delta sigma filter 80, which is easy to pipeline at high speed with no stability issue. The MASH filter 80 receives a refined carrier frequency value FC, e.g. coded over 7 bits, and receives the most significant bits at a first input 81 and the least significant bits at a second input 82. Although a 4th order filter is shown, 2nd or 3rd order may be enough for good dithering of phase and frequency spurs.

An advantage of the emulated bandpass sigma delta modulator of Figures 17 to 19 is that the complete SDM structure includes the function of transposing the baseband input signal 6 or 106 at the RF carrier frequency of interest. It should be noted that the bandpass sigma delta modulator 10 of Figure 2 can be made differently. However, some bandpass sigma delta modulation schemes require the frequency transposition to be done prior to entering the SDM modulator. In other words, some native bandpass SDM structures need an input signal 6 that is not the baseband signal 6, but as an already transposed version of it at carrier frequency FC, thus requiring a much higher oversampling rate F1.

The foregoing modulation devices could be e.g. hardware means like e.g. an ASIC, or a combination of hardware and software means, e.g. an ASIC and an FPGA, or at least one microprocessor and at least one memory with software modules located therein.

The invention is not limited to the described embodiments. The appended claims are to be construed as embodying all modification and alternative constructions that may be occurred to one skilled in the art, which fairly fall within the basic teaching here, set forth.

The use of the verb "to comprise" or "to include" and its conjugations does not exclude the presence of elements or steps other than those stated in a claim. Furthermore, the use of the article "a" or "an" preceding an element or step does not exclude the presence of a plurality of such elements or steps.

In the claims, any reference signs placed between parentheses shall not be construed as limiting the scope of the claims.

## Claims

1. A signal modulation device for providing an output signal (107) to a radio frequency front-end (5), the device comprising:

   an input for receiving a complex input signal (106) comprising an in-phase component signal and a quadrature-phase component signal,
   a sigma-delta modulator (110) for modulating the complex input signal at an oversampling clock rate (F1) into an intermediary signal (112), wherein the intermediary signal takes a first finite number of quantized complex states,
   a numerical oscillator (60) for generating a phase signal (61) oscillating at a selected carrier frequency (FC), wherein the phase signal takes a second finite number of quantized states,

   a symbol mapping table (114) for mapping, at each oversampling clock period, the quantized complex states of the intermediary signal and the quantized complex states of the phase signal to predefined quantized symbols (116) each encoding a pulse train segment of the output signal,
   a pulse generator (117) arranged to receive the quantized symbol (116) selected at each oversampling clock period and to generate the pulse train segment encoded by the received quantized symbol at a second oversampling clock rate (F2), wherein the pulse train segment encoded by a given quantized symbol has, in relation to the entire set of encoded pulse train segments, the complex frequency-domain component at the carrier frequency with the minimum complex plane distance to the complex quantized state of the intermediary signal rotated by the phase angle represented by the quantized state of the phase signal corresponding to said given quantized symbol.

2. The device in accordance with claim 1, further comprising a digital predistortion table (115) for mapping the quantized complex states of the intermediary signal to predefined predistortion symbols (118), and a feedback loop for providing the predistortion symbols (118) to the sigma-delta modulator.

3. The device in accordance with claim 2, wherein the digital predistortion table (115) comprises a predefined predistortion symbol for each quantized complex state of the intermediary signal (112) and each quantized state of the phase signal (61), and operates at each oversampling clock period to select a predistortion symbol as a function of the current quantized complex state of the intermediary signal and the current quantized state of the phase signal.

4. The device in accordance with claim 2 or 3, wherein the predistortion symbol (118) associated to a complex quantized state of the intermediary signal and a quantized state of the phase signal is a function of a frequency-domain complex energy coefficient of the pulse train segment encoded by the corresponding quantized symbol at the carrier frequency (FC) and a complex phase coefficient corresponding to the quantized state of the complex phase signal (61).

5. The device in accordance with any one of claims 1 to 4, wherein the quantized symbol (116) comprises a parallel binary sequence and wherein the pulse generator (117) comprises a serializer adapted to serialize the parallel binary sequence at the second oversampling clock rate (F2).

6. The device in accordance with any one of claims 1 to 6, wherein the phase signal (61) is coded over a predefined number of bits, e.g. over 4 bits.

7. The device in accordance with claim 6, wherein the numerical oscillator (60) comprises a phase accumulator operating as function of a control signal (63) defining the selected carrier frequency coded over the predefined number of bits and a clock signal at the first oversampling clock rate (F1), the device further comprising a multi-stage low pass noise shaping sigma delta filter (80) arranged to provide the control signal (63) coded over the predefined number of bits by filtering a refined control signal (81, 82) coded over a higher number of bits.

8. The device in accordance with any one of claims 1 to 7, further comprising a rate-adjustable clock arranged to provide a clock signal at the first oversampling clock rate (F1), wherein the first oversampling clock rate (F1) is adjustable over a small adjustment range.

9. The device in accordance with any one of claims 1 to 8, wherein the symbol mapping table (114) is obtained by executing the steps of:

> selecting an initial set of pulse train segments having a time-granularity corresponding to a second oversampling clock rate (F2),
> determining a frequency-domain complex energy coefficient of the pulse train segments of the initial set at the carrier frequency (FC), and
> for each quantized state of the phase signal, computing a complex phase coefficient corresponding to the quantized state ($\varphi_k$) of the complex phase signal, and
> selecting a subset of the pulse train segments of which the frequency-domain complex energy coefficients at the carrier frequency closely approximate the quantized complex states of the intermediary signal (112) multiplied by the complex phase coefficient, so that each quantized complex state of the intermediary signal is uniquely mapped to a pulse train segment of the subset,
> for each pulse train segment to which a quantized complex output state is mapped, recording a quantized symbol encoding the pulse train segment at a memory address associated to a combination of the quantized complex state of the intermediary signal (112) combined with the quantized state of the phase signal (61).

10. A signal modulation method for providing an output signal (107) to a radio frequency front-end (5), the method comprising:

> receiving a complex input signal (106) comprising an in-phase component signal and a quadrature-phase component signal,
> sigma-delta modulating the complex input signal at an oversampling clock rate (F1) into an intermediary signal (112), wherein the intermediary signal takes a first finite number of quantized complex states,
> generating a phase signal (61) oscillating at a selected carrier frequency (FC), wherein the phase signal takes a second finite number of quantized states,
> accessing a symbol mapping table (114) at each oversampling clock period (F1) to select a quantized symbol (116) from a set of predefined quantized symbols each symbol encoding a pulse train segment of the output signal as a function of a current quantized complex state of the intermediary signal (112) and a current quantized state of the phase signal (61),
> generating the pulse train segment encoded by the selected quantized symbol with a pulse generator (117) operating at a second oversampling clock rate (F2), wherein the predefined pulse train segment encoded by a given predefined quantized symbol has, in relation to the entire set of encoded pulse train segments, the complex frequency-domain component at the carrier frequency with the minimum complex plane distance to the complex quantized state of the intermediary signal rotated by the phase angle represented by the quantized state of the phase signal corresponding to said given quantized symbol.

**Patentansprüche**

1. Signalmodulator zur Bereitstellung eines Ausgangssignals (107) für ein Radiofrequenz-Frontend (5), wobei die Vorrichtung umfasst:

> einen Eingang für den Empfang eines komplexen Eingangssignals (106), ein InphaseKomponentensignal und ein Quadraturphasenkomponenten-Signal umfassend,
> einen Sigma-Delta-Modulator (110) zur Modulation des komplexen Eingangssignals in einer Überabtastungs-Taktrate (F1) zu einem Zwischensignal (112), wobei das Zwischensignal eine erste endliche Zahl quantisierter komplexer Zustände annimmt,
> einen numerischen Oszillator (60) zur Generierung eines in einer ausgewählten Trägerfrequenz (FC) oszillierenden Phasensignals (61), wobei das Phasensignal eine zweite endliche Zahl quantisierter Zustände annimmt,
> Symbolzuordnungstabelle (114), um in jedem Überabtastungs-Taktzeitraum die quantisierten komplexen Zustände des Zwischensignals und die quantisierten komplexen Zustände des Phasensignals vordefinierten quantisierten Symbolen (116) zuzuordnen, von denen ein jedes ein Impulszugsegment des Ausgangssignals codiert,

einen Impulsgenerator (117), eingerichtet für das Empfangen des im jeweiligen Überabtastungs-Taktzeitraum ausgewählten, quantisierten Symbols (116) und

für das Generieren des vom in einer zweiten Überabtastungs-Taktrate (F2) empfangenen quantisierten Symbol codierten Impulszugsegments, wobei die komplexe Frequenzbereichskomponente des von einem vorgegebenen quantisierten Symbol codierten Impulszugsegments im Verhältnis zum gesamten Satz codierter Impulszugsegmente in der Trägerfrequenz gegenüber dem auf der komplexen Ebene bestehenden Mindestabstand zum quantisierten komplexen Zustand des Zwischensignals um den Phasenwinkel verdreht ist, der vorgegeben ist durch den quantisierten Zustand des dem besagten quantitativen Symbol entsprechenden Phasensignals.

2.  Vorrichtung nach Anspruch 1, die weiterhin umfasst:

    eine Digitalvorverzerrungstabelle (115) für die Zuordnung der komplexen Zustände des Zwischensignals zu vordefinierten Vorverzerrungssymbolen (118) und

    eine Rückkopplungsschleife zur Bereitstellung der Vorverzerrungssymbole (118) für einen Sigma-Delta-Modulator.

3.  Vorrichtung nach Anspruch 2, wobei die Digitalvorverzerrungstabelle (115) für jeden quantisierten komplexen Zustand des Zwischensignals (112) und für jeden quantisierten Zustand des Phasensignals (61) ein vordefiniertes Vorverzerrungssymbol umfasst und in jedem Überabtastungs-Taktzeitraum die Auswahl eines Vorverzerrungssymbols als Funktion des momentanen, quantisierten komplexen Zustands des Zwischensignals und des momentanen quantisierten Zustands des Phasensignals bewirkt.

4.  Vorrichtung nach Anspruch 2 oder 3, wobei das Vorverzerrungssymbol (118), das einem komplexen quantisierten Zustand des Zwischensignals und einem quantisierten Zustand des Phasensignals zugeordnet ist, abhängig ist von einem komplexen Energiekoeffizienten des Frequenzbereichs eines vom zugehörigen quantisierten Symbol in der Trägerfrequenz (FC) codierten Impulszugsegments und eines dem quantisierten Zustand des komplexen Phasensignals (61) entsprechenden, komplexen Phasenkoeffizienten.

5.  Vorrichtung nach jeglichem der Ansprüche 1 bis 4, wobei das quantisierte Symbol (116) eine parallele binäre Sequenz umfasst und wobei der Impulsgenerator (117) einen Serialisierer umfasst, der dafür ausgelegt ist, die parallele binäre Sequenz in der zweiten Überabtastungs-Taktrate (F2) zu serialisieren.

6.  Vorrichtung nach einem jeglichen der Ansprüche 1 bis 5, wobei das Phasensignal (61) über eine vordefinierte Zahl von Bits codiert wird, zum Beispiel über 4 bit.

7.  Vorrichtung nach Anspruch 6, wobei der numerische Oszillator (60) einen Phasenakkumulator umfasst, der in Funktion eines Steuerungssignals (63) arbeitet und die ausgewählte, über die vordefinierte Bitzahl und ein Taktsignal in der ersten Überabtastungs-Taktrate (F1) codierte Trägerfrequenz definiert, wobei die Vorrichtung weiterhin einen mehrstufigen, rauschformenden Sigma-Delta-Tiefpassfilter (80) umfasst, eingerichtet für die Bereitstellung des Steuerungssignals (63), das über die vordefinierte Bitzahl durch das Filtern eines verfeinerten Steuerungssignals (81, 82) codiert wird, das seinerseits über eine höhere Bitzahl codiert wird.

8.  Vorrichtung nach jeglichem der Ansprüche 1 bis 7, weiterhin einen Taktgeber mit einstellbarem Takt umfassend, der eingerichtet ist für die Bereitstellung eines Taktsignals in der ersten Überabtastungs-Taktrate (F1), wobei die erste Überabtastungs-Taktrate (F1) innerhalb eines kleinen Einstellungsbereichs einstellbar ist.

9.  Vorrichtung nach jeglichem der Ansprüche 1 bis 8, wobei die Symbolzuordnungstabelle (114) durch Ausführen der folgenden Schritte erhalten wird:

    Auswählen eines Ausgangssatzes von Impulszugsegmenten mit einer Zeitgranularität, die einer zweiten Überabtastungs-Taktrate (F2) entspricht.
    Festlegen eines komplexen Energiekoeffizienten des Frequenzbereichs der Impulszugsegmente des Ausgangssatzes in der Trägerfrequenz (FC) und für jeden quantisierten Zustand des Phasensignals
    das Berechnen eines komplexen Phasenkoeffizienten, der dem quantisierten Zustand ($\varphi_K$) des komplexen Phasensignals entspricht, und
    das Auswählen eines Teilsatzes an Impulszugsegmenten, bei denen sich die komplexen Energiekoeffizienten des Frequenzbereichs in der Trägerfrequenz stark den vom komplexen Phasenkoeffizienten multiplizierten, quantisierten komplexen Zuständen des Zwischensignals (112) annähern, so dass jeder quantisierte komplexe Zustand des Zwischensignals individuell mit einem Impulszugsegment des Teilsatzes verknüpft wird,
für jedes Impulszugsegment, das mit einem quantisierten komplexen Ausgabezustand verknüpft wird, das Aufzeichnen eines quantisierten Symbols, durch welches das Impulszugsegment unter einer Speicheradresse codiert wird, die einer Kombination des quantisierten komplexen Zustands des Zwischensignals (112) und des quantisierten Zustands des Phasensignals (61) zugeordnet ist.

10. Signalmodulationsverfahren zur Bereitstellung eines Ausgangssignals (107) für ein Radiofrequenz-Frontend (5), wobei das Verfahren umfasst:

den Empfang eines komplexen Eingangssignals (106), ein Inphase-Komponentensignal und ein Quadraturphasenkomponenten-Signal umfassend,
eine Sigma-Delta-Modulation zum Modulieren des komplexen Eingangssignals in einer Überabtastungs-Taktrate (F1) zu einem Zwischensignal (112), wobei das Zwischensignal eine erste endliche Zahl quantisierter komplexer Zustände annimmt,
das Generieren eines in einer ausgewählten Trägerfrequenz (FC) oszillierenden Phasensignals (61), wobei das Phasensignal eine zweite endliche Zahl quantisierter Zustände annimmt,
Zugreifen auf eine Symbolzuordnungstabelle (114) bei jedem Überabtastungs-Taktzeitraum (F1) zum Auswählen eines quantisierten Symbols (116) aus einem Satz vordefinierter quantisierter Symbole,
wobei jedes Symbol ein Impulszugsegment des Ausgangssignals als Funktion eines momentanen, quantisierten komplexen Zustands des Zwischensignals (112) und eines momentanen quantisierten Zustands des Phasensignals (61) codiert,
Generieren des vom ausgewählten quantisierten Symbol mit einem in einer zweiten Überabtastungs-Taktrate (F2) funktionierenden Impulsgenerator (117) codierten Impulszugsegments, wobei die komplexe Frequenzbereichskomponente des von einem vorgegebenen quantisierten Symbol codierten Impulszugsegments im Verhältnis zum gesamten Satz codierter Impulszugsegmente in der Trägerfrequenz gegenüber dem auf der komplexen Ebene bestehenden Mindestabstand zum quantisierten komplexen Zustand des Zwischensignals um den Phasenwinkel verdreht ist, der vorgegeben ist durch den quantisierten Zustand des dem besagten quantitativen Symbol entsprechenden Phasensignals.

**Revendications**

1. Dispositif de modulation de signal pour fournir un signal de sortie (107) à une tête radiofréquence (5), le dispositif comprenant :

une entrée pour recevoir un signal d'entrée complexe (106) comprenant un signal de composante en phase et un signal de composante de phase en quadrature,
un modulateur sigma-delta (110) pour moduler le signal d'entrée complexe à une fréquence d'horloge de suréchantillonnage (F1) en un signal intermédiaire (112), le signal intermédiaire prenant un premier nombre fini d'états complexes quantifiés,
un oscillateur numérique (60) pour générer un signal de phase (61) oscillant à une fréquence porteuse (FC) sélectionnée, le signal de phase prenant un deuxième nombre fini d'états quantifiés,
une table de mappage de symboles (114) pour mapper, à chaque période d'horloge de suréchantillonnage, les états complexes quantifiés du signal intermédiaire et les états complexes quantifiés du signal de phase, à des symboles quantifiés (116) prédéfinis chacun codant un segment de train d'impulsions du signal de sortie,
un générateur d'impulsions (117) conçu pour recevoir le symbole quantifié (116) sélectionné à chaque période d'horloge de suréchantillonnage et
pour générer le segment de train d'impulsions codé par le symbole quantifié reçu à une deuxième fréquence d'horloge de suréchantillonnage (F2), le segment de train d'impulsions codé par un symbole quantifié donné présentant, par rapport à l'ensemble de segments de train d'impulsions codés, la composante complexe du domaine de fréquences à la fréquence porteuse avec la distance de plan complexe minimum jusqu'à l'état quantifié complexe du signal intermédiaire pivoté selon l'angle de phase représenté par l'état quantifié du signal de phase correspondant audit symbole quantifié donné.

2. Dispositif selon la revendication 1, comprenant en outre une table de prédistorsion numérique (115) pour mapper les états complexes quantifiés du signal intermédiaire à des symboles de prédistorsion (118) prédéfinis, et une boucle de rétroaction pour fournir les symboles de prédistorsion (118) au modulateur sigma-delta.

3. Dispositif selon la revendication 2, dans lequel la table de prédistorsion numérique (115) comprend un symbole de prédistorsion prédéfini pour chaque état complexe quantifié du signal intermédiaire (112) et chaque état quantifié du signal de phase (61), et fonctionne à chaque période d'horloge de suréchantillonnage pour sélectionner un symbole de prédistorsion en fonction de l'état complexe quantifié actuel du signal intermédiaire et de l'état quantifié actuel du signal de phase.

**4.** Dispositif selon la revendication 2 ou 3, dans lequel le symbole de prédistorsion (118) associé à un état quantifié complexe du signal intermédiaire et à un état quantifié du signal de phase est fonction d'un coefficient énergétique complexe du domaine de fréquences du segment de train d'impulsions codé par le symbole quantifié correspondant à la fréquence porteuse (FC) et d'un coefficient de phase complexe correspondant à l'état quantifié du signal de phase complexe (61).

**5.** Dispositif selon l'une quelconque des revendications 1 à 4, dans lequel le symbole quantifié (116) comprend une séquence binaire parallèle et dans lequel le générateur d'impulsions (117) comprend un convertisseur parallèle-série adapté pour convertir de parallèle en série la séquence binaire parallèle à la deuxième fréquence d'horloge de suréchantillonnage (F2).

**6.** Dispositif selon l'une quelconque des revendications 1 à 6, dans lequel le signal de phase (61) est codé sur un nombre de bits prédéfini, par exemple plus de 4 bits.

**7.** Dispositif selon la revendication 6, dans lequel l'oscillateur numérique (60) comprend un accumulateur de phase fonctionnant en fonction d'un signal de commande (63) définissant la fréquence porteuse sélectionnée codée sur le nombre de bits prédéfini et un signal d'horloge à la première fréquence d'horloge de suréchantillonnage (F1), le dispositif comprenant en outre un filtre sigma-delta à mise en forme du bruit passe-bas à étages multiples (80) conçu pour fournir le signal de commande (63) codé sur le nombre de bits prédéfini en filtrant un signal de commande affiné (81, 82) codé sur un nombre de bits plus élevé.

**8.** Dispositif selon l'une quelconque des revendications 1 à 7, comprenant en outre une horloge à fréquence réglable conçue pour fournir un signal d'horloge à la première fréquence d'horloge de suréchantillonnage (F1), la première fréquence d'horloge de suréchantillonnage (F1) étant réglable sur une petite plage de réglage.

**9.** Dispositif selon l'une quelconque des revendications 1 à 8, dans lequel la table de mappage de symboles (114) est obtenue en exécutant les étapes suivantes :

sélectionner un ensemble initial de segments de train d'impulsions présentant une granularité temporelle correspondant à une deuxième fréquence d'horloge de suréchantillonnage (F2), déterminer un coefficient énergétique complexe du domaine de fréquences des segments de train d'impulsions de l'ensemble initial à la fréquence porteuse (FC), et

pour chaque état quantifié du signal de phase, calculer un coefficient de phase complexe correspondant à l'état quantifié ($\varphi_K$) du signal de phase complexe, et

sélectionner un sous-ensemble des segments de train d'impulsions dont les coefficients énergétiques complexes du domaine de fréquences à la fréquence porteuse se rapprochent le plus des états complexes quantifiés du signal intermédiaire (112) multiplié par le coefficient de phase complexe, de sorte que chaque état complexe quantifié du signal intermédiaire soit uniquement mappé à un segment de train d'impulsions du sous-ensemble,

pour chaque segment de train d'impulsions auquel un état de sortie complexe quantifié est mappé, enregistrer un symbole quantifié codant le segment de train d'impulsions à une adresse de mémoire associée à une combinaison de l'état complexe quantifié du signal intermédiaire (112) combiné à l'état quantifié du signal de phase (61).

**10.** Procédé de modulation de signal pour fournir un signal de sortie (107) à une tête radiofréquence (5), le procédé comprenant les étapes suivantes :

recevoir un signal d'entrée complexe (106) comprenant un signal de composante en phase et un signal de composante de phase en quadrature,

moduler en sigma-delta le signal d'entrée complexe à une fréquence d'horloge de suréchantillonnage (F1) en un signal intermédiaire (112), le signal intermédiaire prenant un premier nombre fini d'états complexes quantifiés,

générer un signal de phase (61) oscillant à une fréquence porteuse (FC) sélectionnée, le signal de phase prenant un deuxième nombre fini d'états quantifiés,

accéder à une table de mappage de symboles (114) à chaque période d'horloge de suréchantillonnage (F1) pour sélectionner un symbole quantifié (116) parmi un ensemble de symboles quantifiés prédéfinis, chaque symbole codant un segment de train d'impulsions du signal de sortie en fonction d'un état complexe quantifié actuel du signal intermédiaire (112) et d'un état quantifié actuel du signal de phase (61),
générer le segment de train d'impulsions codé par le symbole quantifié sélectionné avec un générateur d'impulsions (117) fonctionnant à une deuxième fréquence d'horloge de suréchantillonnage (F2), le segment de train d'impulsions prédéfini codé par un symbole quantifié prédéfini donné présentant, par rapport à l'ensemble de segments de train d'impulsions codés, la composante complexe du domaine de fréquences à la fréquence porteuse avec la distance de plan complexe minimum jusqu'à l'état quantifié complexe du signal intermédiaire pivoté selon l'angle de phase représenté par l'état quantifié du signal de phase correspondant audit symbole quantifié donné.

FIG.1

FIG.2

FIG.3

FIG.4

R = 1/2    N = 16

FIG.5

R = 15/16    N = 16

FIG.6

FIG.7

FIG.9

FIG.10

FIG.11

FIG.12

FIG.8

FIG.13

FIG.14

FIG.15

20

FIG.16

EP 2 728 746 B1

FIG.17

EP 2 728 746 B1

EP 2 728 746 B1

*M

*N

FO

F1

F2

110

111

112

113

114

116

117

Base
band
I&Q

LOW pass
SDM

quan
tizer

Pulses
Codebook

Serializer
N bits

RF
pulse
train

106

61

61

NCO
-F1/2
to
+F1/2

Instant
LO
phase

Codebook
Complex
power
transposed

107

F1

FC

115

60

SDM feedback

118

FIG.18

FIG.19

FIG.20

SELECT INITIAL SET — 40

COMPUTE COMPLEX ENERGY AT CARRIER FREQ. — 41

SUPER IMPOSE DENSE PORTION OF CONSTELLATION TO CONSTELLATION OF INTER MEDI ARY SIGNAL — 42

MAP CONSTELLATION OF INTERMEDIARY SIGNAL TO SUBSET OF PULSE TRAIN SEGMENTS — 43

STORE PULSE CODES AND COMPLEX POWERS IN MEMORY — 44

FIG.21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2330734 A1
- EP 2403136 A1

- WO 200197384 A1
- WO 9215153 A2

**Non-patent literature cited in the description**

- **CRAVEN P.** Toward the 24-bit DAC: novel noise-shaping topologies incorporating correction for the nonlinearity in a PWM output stage. *J. Audio Eng. Soc.,* vol. 41 (5